Europäisches Patentamt

European Patent Office

Office européen des brevets

(19)

(11) Numéro de publication: **0 012 656**
**B1**

(12)

# FASCICULE DE BREVET EUROPEEN

(45) Date de publication du fascicule du brevet: **11.01.84**

(21) Numéro de dépôt: **79400939.9**

(22) Date de dépôt: **30.11.79**

(51) Int. Cl.³: **H 03 J 5/02,** H 03 J 7/16,
H 03 L 7/18, H 04 B 1/26

(54) Dispositif d'accord automatique d'un résonateur et synthétiseur utilisant un tel dispositif.

(30) Priorité: **15.12.78 FR 7835386**

(43) Date de publication de la demande:
**25.06.80 Bulletin 80/13**

(45) Mention de la délivrance du brevet:
**11.01.84 Bulletin 84/2**

(84) Etats contractants désignés:
**DE GB IT**

(56) Documents cités:
**DE - A - 2 626 290**
**DE - C - 737 075**
**DE - C - 861 875**
**FR - A - 1 461 814**
**FR - A - 2 382 133**
**FR - A - 2 397 096**
**US - A - 3 441 870**

(73) Titulaire: **THOMSON-CSF**
**173, Boulevard Haussmann**
**F-75379 Paris Cedex 08 (FR)**

(72) Inventeur: **Parniere, Alain**
**"THOMSON-CSF" - SCPI 173, bld Haussmann**
**F-75360 Paris Cedex 08 (FR)**
Inventeur: **Hautbout, Jean-Marie**
**"THOMSON-SCF" - SCPI 173, bld Haussmann**
**F-75360 Paris Cedex 08 (FR)**

(74) Mandataire: **Courtellemont, Alain et al,**
**THOMSON-CSF SCPI 173, Bld Haussmann**
**F-75379 Paris Cedex 08 (FR)**

Courier Press, Leamington Spa, England.

Dispositif d'accord automatique d'un résonateur et synthétiseur
utilisant un tel dispositif

La présente invention concerne les dispositifs d'accord d'un résonateur, en particulieur, ceux qui équipent les oscillateurs commandés électroniquement en fréquence, utilisés dans les générateurs de fréquence variable par pas comportant essentiellement un diviseur de fréquence, à nombre diviseur variable, et un comparateur recevant le signal de sortie du diviseur et une fréquence de référence constituant le pas de ces générateurs, qui seront appelés dans ce qui suit synthétiseurs à boucle d'asservissement.

Les qualités essentiellement exigées de ces synthétiseurs sont une grande pureté spectrale, une grande résolution et une large bande d'accord. Elles sont obtenues en associant à l'élément électronique faiblement couplé, un accord mécanique qui peut être un plongeur diélectrique d'enfoncement variable dans une cavité résonnante ou un condensateur variable, ou une ligne coaxiale de longueur réglable.

Le brevet US 3 441 870 décrit un dispositif où la fréquence et la phase de l'oscillateur sont réglées par un étage à réactance variable et par un condensateur variable mû par un moteur. Le premier est commandé par un comparateur de phase, alors que le second est commandé par un comparateur de fréquence. Dans le cas où une forte dérive d'accord se produit, le réglage fin réalisé par l'étage à réactance variable arrivant en butée le verrouillage de phase est perdu, le comparateur de fréquence détecte alors une erreur de fréquence et met en oeuvre le réglage grossier constitué par le condensateur variable. Dans ce dispositif il est nécessaire de perdre le verrouillage de phase pour qu'apparaisse une erreur de fréquence commandant le réglage grossier. Il y a donc des périodes transitoires pendant lesquelles le verrouillage de phase est perdu, ce qui constitue un inconvénient majeur lorsque le dispositif synthétiseur pilote un faisceau hertzien numérique, où les informations sont constituées de sauts de phase.

La présente invention a pour objet de remédier à cet inconvénient à l'aide de moyens simples.

Selon l'invention, un dispositif d'accord d'un résonateur associé à un oscillateur à fréquence variable, comportant un premier dispositif et un deuxième dispositif de commande de la fréquence d'accord, le deuxième étant un dispositif mécanique; un dispositif, transformateur de la fréquence de l'oscillateur, comportant au moins un diviseur à nombre diviseur variable; un dispositif de commande fournissant, à une entrée du dispositif transformateur, un signal représentatif du nombre diviseur; un comparateur de phase recevant un signal alternatif de référence et un signal fourni par le dispositif transformateur de la fréquence de l'oscillateur, et fournissant un signal d'asservissement; un filtre passe-bas filtrant ce signal d'asservissement et restituant un signal de valeur $V_a$, en fonction duquel le premier dispositif de commande agit continument quelle que soit la valeur $V_a$ supérieure ou égale à une borne $V_1$, et inférieure ou égale à une borne $V_4$, $V_4$ étant supérieure à $V_1$; est caractérisé en ce que le deuxième dispositif de commande agit si la valeur $V_a$ atteint la borne $V_1$, ou la borne $V_4$, pour ramener la valeur $V_a$ respectivement à une valeur $V_2$ strictement supérieure à $V_1$ et à une valeur $V_3$ strictement inférieure à $V_4$.

L'invention sera mieux comprise et d'autres caractéristiques apparaîtront à l'aide de la description ci-après et des schémas s'y rapportant sur lesquels:

— la figure 1 est un schéma de principe d'un dispositif d'accord selon l'invention, appliqué à un synthétiseur;

— les figures 2 et 3 sont des modes de réalisation d'organes de la figure 1.

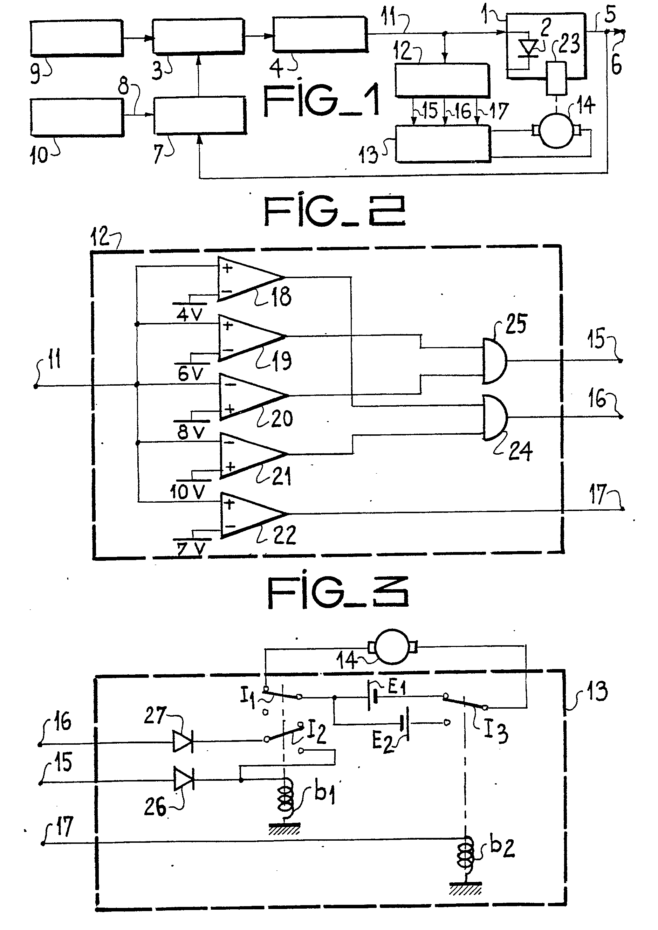

Sur la figure 1, un oscillateur à contrôle électronique de la fréquence est représente par une cavité résonnante 1 comportant une diode 2, dont la capacité est variable en fonction d'une tension $V_a$ fournie par un comparateur de phase 3 à travers un filtre passe-bas 4. Il est prélevé par une sortie 5 l'énergie pour alimenter une borne de sortie 6 reliée également à un diviseur 7 à coefficient de division variable. Le diviseur 7 alimente une première entrée du comparateur 3 dont une seconde entrée reçoit le signal de sortie d'un oscillateur de référence 9.

Le diviseur 7 a une entrée de commande 8 alimentée par une organe de codage 10 de la fréquence désirée: roues codeuses, dans le cas d'une commande manuelle, "bus" d'assignation numérique dans le cas d'une télécommande par calculateur.

Un convertisseur analogique-numérique 12 dont l'entrée est reliée à la sortie 11 du filtre de boucle 4 reçoit la tension d'asservissement $V_a$ et délivre respectivement à ses sorties 15, 16 et 17 des signaux binaires A, B et C commandant un circuit d'alimentation 13 d'un moteur électrique 14, couplé mécaniquement à un plongeur diélectrique 23 d'enfoncement variable dans la cavité par l'intermédiaire d'un dispositif de transformation rotatif/linéaire classique composé d'une roue et d'une crémaillère.

De cette manière, il est possible de réduire la plage d'accord électronique de la cavité 1, à condition que le sens de rotation du moteur soit tel que tout accroissement $\Delta V_a$ de la tension $V_a$ provoque un déplacement du plongeur diélectrique 23 dans un sens tel que la variation d'accord correspondante ait le même signe que celle provoquée par $\Delta V_a$. Ainsi l'impact de la diode 2 sur la surtension de la cavité se trouve diminué. Il en résultera une amélioration de la pureté spectrale de l'oscillateur.

La figure suivante montre un exemple de réalisation du convertisseur analogique numérique 12.

Sur la figure 2, des comparateurs 18, 19, 20, 21 et 22 reçoivent sur une première entrée le signal d'asservissement $V_a$, et respectivement sur une deuxième entrée des tensions continues 4V, 6V, 8V, 10V, 7V. Ils délivrent sur leur sortie des niveaux logiques tels que l'état 1 est obtenu respectivement pour $V_a > 4V$, $V_a > 6V$, $V_a < 8V$, $V_a < 10V$, $V_a > 7V$, et l'état 0 dans le cas contraire.

Une porte ET, 25, reçoit sur une de ses deux entrées, la sortie du comparateur 19, sur l'autre entrée la sortie du comparateur 20, et fournit sur sa sortie 15 un niveau logique 1 pour $V_a$ comprise entre 6V et 8V. Une deuxième porte ET, 24, reçoit sur une de ses deux entrées, la sortie du comparateur 18 et sur l'autre entrée la sortie du comparateur 21, l'état logique 1 étant cette fois-ci obtenu sur sa sortie 16 pour $V_a$ comprise entre 4V et 10V. La sortie du comparateur 22 est reliée directement à la borne 17.

La zone de valeurs comprises entre 4V et 10V correspond à une plage préférentielle de la valeur de la tension d'asservissement permettant de s'affranchir largement des zones de déchets d'un amplificateur opérationnel contenu dans le filtre passe bas 4, supposé être dans cet exemple un filtre actif classique.

La figure suivante représente un exemple de réalisation du circuit d'alimentation 13 du moteur électrique 14.

Sur la figure 3, un commutateur $I_3$ relie une extrémité du moteur électrique 14, soit à la borne négative d'une alimentation $E_1$, soit à la borne positive d'une alimentation $E_2$. La borne positive de l'alimentation $E_1$ commune à la borne négative de l'alimentation $E_2$ est reliée à l'autre extrémité du moteur par l'intermédiaire d'un interrupteur $I_1$. La sortie 15 est reliée à l'anode d'une diode 26. La cathode de cette diode 26 est reliée à la masse par l'intermédiaire d'une bobine $b_1$, et à la cathode d'une diode 27 par l'intermédiaire d'une interrupteur $I_2$. L'anode de cette diode 27 est reliée à la sortie 16. Une bobine $b_2$ reçoit sur l'une de ses extrémités le signal C de la sortie 17, et sur l'autre la masse.

Les deux interrupteurs $I_1$, $I_2$ et la bobine $b_1$ forment un premier relais double $R_1$, lorsque le signal dans la bobine $b_1$ est nul, $I_1$ est fermé et $I_2$ est ouvert.

Le commutateur $I_3$ et la bobine $b_2$ forment un deuxième relais $R_2$. Un changement de l'état logique du signal C dans la bobine $b_2$ commande la commutation de $I_3$.

Le fonctionnement détaillé du dispositif d'accord du résonateur est le suivant: Après la mise sous tension du système et l'affichage de la fréquence désirée à l'aide de l'organe de codage, le filtre de boucle délivre une tension d'asservissement $V_a$. Deux cas différents peuvent se présenter. Premier cas, la fréquence assignée est proche de celle qui est donnée par la borne 6 de sortie du résonateur, $V_a$ est comprise entre 6V et 8V, le verrouillage en phase s'effectue, la sortie 15 est au niveau logique 1, le relais $R_1$ est activé ce qui ouvre le circuit d'alimentation du moteur 14. Deuxième cas, $V_a$ inférieure à 6V ou supérieure à 8V, le signal A de la sortie 15 est au niveau logique 0, le relais $R_1$ est au repos, le moteur 14 agit sur le plongeur diélectrique. Dès que la valeur de $V_a$ aura atteinte 6V ou 8V, le relais $R_1$ sera activé, l'interrupteur $I_1$ coupera l'alimentation du moteur 14, l'interrupteur $I_2$ se fermera. Le signal B de la sortie 16 étant à la valeur logique 1, le relais $R_1$ restera activé tant que $V_a$ sera comprise entre 4V et 10V. L'interrupteur $I_2$ et la bobine $b_1$ ont une fonction de mémoire qui permet d'éviter un état instable, en l'absence de l'interrupteur $I_2$ le moteur 14 aurait tendance à être réalimenté.

Le relais $R_2$ permet d'inverser la polarité l'alimentation du moteur 14 afin d'agir dans un sens qui permet d'approcher la fréquence désirée selon que $V_a$ est supérieure ou inférieure à 7V.

La tension d'asservissement $V_a$ peut évoluer entre 4V et 10V, sans que le dispositif d'accord automatique intervienne, soit sous l'effet de l'influence de la température sur la cavité, soit lorsque l'on effectue des incréments de fréquences suffisamment faibles à de l'organe de codage pour ne pas sortir de la plage de l'asservissement de 4V à 10V.

Un tel dispositif permet lors d'un changement de fréquence assignée de se recaler automatiquement sur la zone de fonctionnement utile. Et surtout il permet d'obtenir une haute pureté spectrale dans une grande bande de fréquence, et un verrouillage garanti quelles que soient les dérives de la cavité, ce qui n'est pas vrai dans le cas d'un prépositionnement manuel.

Il est à noter que le circuit d'alimentation du moteur et donc les moyens de commande de ce circuit peuvent varier suivant le type de moteur utilisé. D'autre part, dans le mode de réalisation décrit, cinq valeurs particulières de tension de référence des comparateurs 18, 19, 20, 21 et 22 ont été choisies, mais il est à la portée de l'homme de l'art de réaliser la structure avec des valeurs différentes.

**Revendications**

1. Dispositif d'accord d'un résonateur (1) associé à un oscillateur à fréquence variable, comportant un premier dispositif (2) et un deuxième dispositif (23, 12, 13, 14) de commande de la fréquence d'accord, le deuxième étant un dispositif mécanique; un dispositif (7), transformateur de la fréquence de l'oscillateur, comportant au moins un diviseur à nombre diviseur variable; un dispositif de commande (10) fournissant, à une entrée du dispositif transformateur (7), un signal représentatif du nombre diviseur; un comparateur de phase (3) recevant un signal alternatif de référence et un signal fourni par le dispositif (7) transformateur de la fréquence de l'oscillateur, et fournissant un signal d'asservissement; un filtre passe-bas (4) filtrant ce signal d'asservissement et restituant un signal de valeur $V_a$, en fonction duquel le premier dispositif de commande (2) agit continument quelle que soit la valeur $V_a$ supérieure ou égale à une borne $V_1$, et inférieure ou égale à une borne $V_4$, $V_4$ étant supérieure à $V_1$; caractérisé en ce que le deuxième dispositif de commande (23, 12, 13, 14) agit si la valeur $V_a$ atteint la borne $V_a$, ou la borne $V_4$, pour ramener la valeur $V_a$ respectivement à une valeur $V_2$ strictement supérieure à $V_1$ et à valeur $V_3$ strictement inférieure à $V_4$.

2. Dispositif d'accord selon la revendication 1, caractérisé en ce que le résonateur est une cavité (1); en ce que le premier dispositif de commande de la fréquence est une diode (2) à capacité variable, alimentée par le signal d'asservissement filtré, de valeur $V_a$; et en ce que le deuxième dispositif de commande d'accord comporte un plongeur diélectrique (23), pénétrant dans la cavité (11), et dont la position est réglée par un moteur électrique (14); un dispositif (12 et 13) de commande du moteur (14) en fonction de la valeur $V_a$ du signal d'asservissement filtré.

3. Dispositif d'accord selon la revendication 2, caractérisé en ce que le dispositif de commande (12 et 13) du moteur (14) comporte des moyens pour le faire tourner dans un sens lorsque la valeur $V_a$ est égale à la valeur $V_1$ et le maintenir en rotation dans ce sens jusqu'à ce que la valeur $V_a$ atteigne la valeur $V_2$; pour le faire tourner dans l'autre sens quand la valeur $V_a$ est égale à la borne $V_4$ et le maintenir en rotation dans cet aure sens jusqu'à ce que la valeur $V_a$ atteigne la valeur $V_3$.

4. Synthétiseur de fréquence à boucle d'asservissement, caractérisé en ce qu'il comporte un dispositif d'accord selon l'une des revendications 1 à 3.

**Patentansprüche**

1. Abstimmvorrichtung zur Abstimmung eines Resonators (1), der einem mit variabler Frequenz arbeitenden Oszillator zugeordnet ist, mit einer ersten Vorrichtung (2) und einer zweiten Vorrichtung (23, 12, 13, 14) zur Steuerung der Abstimmfrequenz, wobei die zweite Vorrichtung eine mechanische Vorrichtung ist; einer die Oszillatorfrequenz umsetzenden Vorrichtung (7), die wenigstens einen Teiler mit variabler Teilerzahl umfaßt, einer Steuervorrichtung (10), die an einen Eingang der Umsetzvorrichtung (7) ein Signal anlegt, welches die Teilerzahl darstellt, einem Phasenvergleicher (3), der ein Referenz-Wechselsignal und ein von der Umsetzvorrichtung (7) zur Umsetzung der Oszillatorfrequenz geliefertes Signal empfängt und ein Regelsignal liefert, mit einem Tiefpaßfilter (4), welches dieses Regelsignal filtert und ein Signal mit dem Wert $V_a$ wieder-

gibt, in Abhängigkeit von welchem die erste Steuervorrichtung (2) kontinuierlich wirksam ist, und zwar unabhängig davon, ob der Wert $V_a$ größer oder gleich einem Grenzwert $V_1$ und kleiner als oder gleich einem Grenzwert $V_4$ ist, worin $V_4$ größer als $V_1$ ist; dadurch gekennzeichnet, daß die zweite Steuervorrichtung (23, 12, 13, 14) wirksam ist, wenn der Wert $V_a$ den Grenzwert $V_1$ erreicht, um den Wert $V_a$ auf einen Wert $V_2$ zurückzubringen, der streng größer als $V_1$ ist, oder wenn der Wert $V_a$ den Grenzwert $V_4$ erreicht, um den Wert $V_a$ auf einen Wert $V_3$ zurückzubringen, der streng kleiner also $V_4$ ist.

2. Abstimmvorrichtung nach Anspruch 1, dadurch gekennzeichnet, daß der Resonator ein Hohlraum (1) ist; daß die erste Frequenzsteuervorrichtung eine Diode (2) mit variabler Kapazität ist, welche durch das gefilterte Regelsignal mit dem Wert $V_a$ gespeist wird; und daß die zweite Abstimmsteuervorrichtung ein dielektrisches Eintauchelement (23), das in den Hohlraum (11) eindringt und dessen Stellung durch einen Elektromotor (14) eingestellt wird, und eine Vorrichtung (12 und 13) zur Steuerung des Motors (14) in Abhängigkeit von dem Wert $V_a$ des gefilterten Regelsignals umfaßt.

3. Abstimmvorrichtung nach Anspruch 2, dadurch gekennzeichnet, daß die Steuervorrichtung (12 und 13) zur Steuerung des Motors (14) Mittel umfaßt, um ihn in dem einen Drehsinn rotieren zum lassen, wenn der Wert $V_a$ gleich dem Wert $V_1$ ist, und um ihn in diesem Drehsinn in Drehung zu halten, bis der Wert $V_a$ den Wert $V_2$ erreicht, sowie um ihn mit dem anderen Drehsinn rotieren zu lassen, wenn der Wert $V_a$ gleich dem Grenzwert $V_4$ ist, und ihn in diesem anderen Drehsinn in Drehung zu halten, bis der Wert $V_a$ den Wert $V_3$ erreicht.

4. Frequenzsynthese-Regelschleife, dadurch gekennzeichnet, daß sie eine Abstimmvorrichtung nach einem der Ansprüche 1 bis 3 enthält.

**Claims**

1. Device for tuning a resonator (1) associated with a variable frequency oscillator, comprising a first device (2) and a second device (23, 12, 13, 14) for controlling the tuning frequency, the second being a mechanical device; a device (7) for converting the oscillator frequency, comprising at least one divider having a variable divisor; a control device (10) supplying a signal representative of the divisor to one input of the converter device (7); a phase comparator (3) receiving an alternating reference signal and a signal supplied by the oscillator frequency converter device (7) and supplying a slaving signal; a low-pass filter (4) filtering this slaving signal and restituting a signal of the value $V_a$, the first control device (2) continuously acting in dependence on this signal regardless whether the value $V_a$ is above or equal to a limit $V_1$ and below or equal to a limit $V_4$, $V_4$ exceeding $V_1$; characterized in that the second control device (23, 12, 13, 14) is active if the value $V_a$ reaches the limit $V_1$, or the limit $V_4$, to restore the value $V_a$ to a value $V_2$ strictly exceeding $V_1$, and to a value $V_3$ strictly below $V_4$, respectively.

2. Tuning device according to claim 1, characterized in that the resonator is a cavity (1); in that the first frequency control device is a variable capacity diode (2) fed by the filtered slaving signal of the value $V_a$; and in that the second tuning control device comprises a dielectric plunger (23) penetrating into the cavity (11) and the position of which is adjusted by an electrical motor (14); and a device (12 and 13) for controlling the motor (14) in dependence on the value $V_a$ of the filtered slaving signal.

3. Tuning device according to claim 2, characterized in that the device (12 and 13) for controlling the motor (14) comprises means for rotating the same in one sense when the value $V_a$ is equal to the value $V_1$ and to maintain it rotating in this sense until the value $V_a$ reaches the value $V_2$; and to rotate the motor in the other sense when the value $V_a$ is equal to the limit $V_4$ and to maintain rotation in this sense until the value $V_a$ reaches the value $V_3$.

4. Closed loop frequency synthesizer, characterized in that it comprises a tuning device in accordance with any of claims 1 to 3.

0 012 656

FIG_1

FIG_2

FIG_3

1